# EUROPEAN PATENT APPLICATION

(11) **EP 3 780 098 A1**
(43) Date of publication of application: **17.02.2021**
(21) Application number: 19925841.9
(22) Date of filing: 24.04.2019
(51) Int. Cl.: H01L 23/64

(54) **CAPACITOR AND PREPARATION METHOD THEREFOR**

(71) Applicant: SHENZHEN GOODIX TECHNOLOGY CO., LTD., Shenzhen, Guangdong 518045 (CN)
(72) Inventor: LU, Bin, Shenzhen, Guangdong 518045 (CN); SHEN, Jian, Shenzhen, Guangdong 518045 (CN)
(74) Representative: Herrero & Asociados, S.L.
(86) International application number: PCT/CN2019/084153
(87) International publication number: WO 2020/215260

(57) **Abstract**

A capacitor and a method for producing the same are provided. The capacitor includes a first electrode (1111) and a second electrode (1112); a laminated structure (160) including a first conductive layer, at least one dielectric layer (162, 164) and at least one second conductive layer (163, 165), where the first conductive layer includes at least one groove-shaped support (1611), the at least one dielectric layer and the at least one second conductive layer cover the at least one groove-shaped support, and the first conductive layer, the at least one dielectric layer and the at least one second conductive layer form a structure that a dielectric layer and a conductive layer are adjacent to each other; and an interconnection structure (190) configured to at least connect the first electrode and the second electrode to two adjacent conductive layers respectively. A laminated structure that a conductive layer and a dielectric layer are alternately stacked is adopted, which could improve capacitance density of the capacitor could be improved, and the laminated structure is produced by using the at least one groove-shaped support, which could improve laminated density of the laminated structure.

## Description

### TECHNICAL FIELD

The present application relates to the field of capacitors, and in particular, to a capacitor and a method for producing the same.

### BACKGROUND

A capacitor may play a role of bypassing, filtering, decoupling, or the like in a circuit, which is an indispensable part for ensuring a normal operation of the circuit. As modern electronic systems continue to develop towards multi-function, high integration, low power consumption and miniaturization, an existing capacitor manufacturing technology has been unable to meet the diversified needs of various high-end applications.

A wafer-level three-dimensional (3D) capacitor is a new type of capacitor manufactured on a silicon wafer by utilizing a semiconductor processing technology in recent years. Compared with a commonly used multilayer ceramic capacitor, the wafer-level three-dimensional capacitor has significant advantages in terms of minimum chip thickness, frequency response, and temperature coefficient. The wafer-level 3D capacitor has a wide range of applications in consumer electronics that require an extremely small size of a device, or medical, vehicle-mounted device, aerospace electronics, etc., that require strict device performance and reliability.

However, at present, capacitance density of the wafer-level 3D capacitor is still limited, and how to improve the capacitance density of the capacitor has become an urgent technical problem to be resolved.

### SUMMARY

Embodiments of the present application provide a capacitor and a method for producing the same, which could improve capacitance density of the capacitor.

In a first aspect, a capacitor is provided, including:
a first electrode and a second electrode;
a laminated structure including a first conductive layer, at least one dielectric layer and at least one second conductive layer, where the first conductive layer includes at least one groove-shaped support, the at least one dielectric layer and the at least one second conductive layer cover the at least one groove-shaped support, and the first conductive layer, the at least one dielectric layer and the at least one second conductive layer form a structure that a dielectric layer and a conductive layer are adjacent to each other; and
an interconnection structure configured to at least connect the first electrode and the second electrode to two adjacent conductive layers respectively.

According to a capacitor of an embodiment of the present application, a capacitor is formed using a laminated structure that a conductive layer and a dielectric layer are alternately stacked, so that a larger capacitance value may be obtained in a case of a smaller device size, and thus capacitance density of the capacitor could be improved. In addition, the laminated structure is produced by using at least one groove-shaped support, laminated density of the laminated structure could be improved, and the capacitance value of the capacitor could be further increased, so that the capacitance density of the capacitor could be improved.

In a second aspect, a method for producing a capacitor is provided, including:
producing at least one groove-shaped support on a substrate to obtain a first conductive layer;
producing at least one dielectric layer and at least one second conductive layer on the first conductive layer to obtain a laminated structure, where the at least one dielectric layer and the at least one second conductive layer cover the at least one groove-shaped support, and the first conductive layer, the at least one dielectric layer and the at least one second conductive layer form a structure that a dielectric layer and a conductive layer are adjacent to each other;
producing an insulating structure including an interconnection structure on the laminated structure; and
producing a first electrode and a second electrode on the insulating structure, where the first electrode and the second electrode are at least connected to two adjacent conductive layers respectively.

According to a method for producing a capacitor provided by an embodiment of the present invention, a laminated structure including more conductive layers and dielectric layers may be obtained, thereby improving a capacitance value of the capacitor. In addition, the laminated structure is produced by using at least one groove-shaped support, a laminated density of the laminated structure could be improved, and the capacitance value of the capacitor could be further increased, so that the capacitance density of the capacitor could be improved.

In a third aspect, a capacitor is provided, including:
the capacitor produced according to the method of the second aspect.

### BRIEF DESCRIPTION OF THE DRAWINGS

FIG. 1 is a schematic structural diagram of a capacitor according to an embodiment of the present application.
FIG. 2 is another schematic structural diagram of a capacitor according to an embodiment of the present application.
FIG. 3 is a partial schematic structural diagram of a modified structure of the capacitor shown in FIG. 2.
FIG. 4 is a partial schematic structural diagram of another modified structure of the capacitor shown in FIG. 2.
FIG. 5 is a schematic flow chart of a method for producing a capacitor according to an embodiment of the present application.
FIGS. 6 to 19 are schematic process flow charts for producing the capacitor shown in FIG. 1.
FIGS. 20 to 31 are schematic process flow charts for producing the capacitor shown in FIG. 2.

### DESCRIPTION OF EMBODIMENTS

Technical solutions in embodiments of the present application will be described hereinafter with reference to the accompanying drawings.

It should be understood that a capacitor of an embodiment of the present application may play a role of bypassing, filtering, decoupling, or the like in a circuit.

The capacitor described in the embodiment of the present application may be a 3D silicon capacitor which is a novel capacitor based on semiconductor wafer processing techniques. Compared with a traditional multi-layer ceramic capacitor (Multilayer ceramic capacitor, MLCC), the 3D silicon capacitor has advantages of small size, high precision, strong stability, long lifetime, or the like. In a basic processing flow, a 3D structure with a high depth-to-width ratio, such as a deep hole (Via), a trench (Trench), a pillar (Pillar) shape, a wall (Wall) shape, or the like is required to be first processed on a wafer or substrate, and then an insulating film and a low-resistivity conductive material are deposited on a surface of the 3D structure to produce a lower electrode, a dielectric layer and an upper electrode of the capacitor, sequentially.

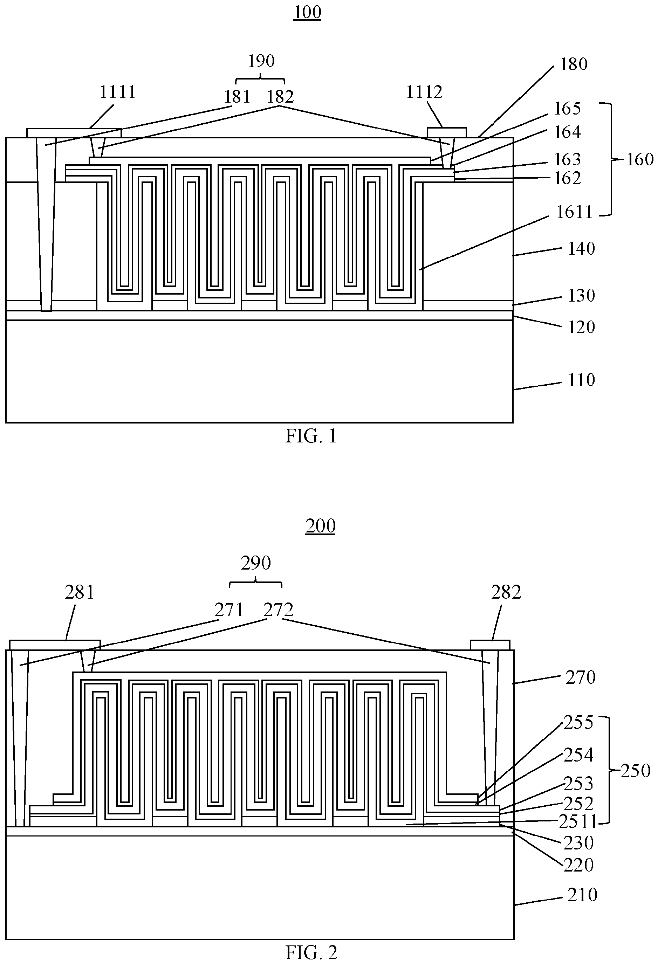

Hereinafter, a capacitor and a method for producing the same according to the present application will be introduced in detail with reference to FIGS. 1 to 31.

It should be noted that, for ease of description, in embodiments of the present application, same components are denoted by same reference numerals, and detailed description for the same components is omitted in different embodiments for brevity. It should be understood that dimensions such as thicknesses, lengths and widths of various components in the embodiments of the present application shown in the drawings, as well as dimensions of the overall thickness, length and width of an integrated apparatus are merely illustrative, and should not constitute any limitation to the present application.

In addition, to facilitate understanding, in the embodiments shown below, for the structures shown in different embodiments, the same structures are denoted by the same reference numbers, and detailed description for the same structures is omitted for brevity.

FIG. 1 is a schematic structural diagram of a capacitor 100 according to an embodiment of the present application.

As shown in FIG. 1, the capacitor 100 may include a first electrode 1111, a second electrode 1112, a laminated structure 160 and an interconnection structure 190.

The first electrode 1111 and the second electrode 1112 are positive and negative electrodes of the capacitor 100. The first electrode 1111 and the second electrode 1112 are separated from each other to form electrode layers. Materials of the first electrode 1111 and the second electrode 1112 may adopt various conductive materials, such as a metal of aluminum. The first electrode 171 and the second electrode 172 may be implemented in a manner of a pad or a solder ball.

The laminated structure 160 may include a first conductive layer, at least one dielectric layer and at least one second conductive layer, where the first conductive layer includes at least one groove-shaped support (also referred to as a cup-shaped support), the at least one dielectric layer (also referred to as an insulating layer) and the at least one second conductive layer cover the at least one groove-shaped support, and the first conductive layer, the at least one dielectric layer and the at least one second conductive layer form a structure that a dielectric layer and a conductive layer are adjacent to each other.

The dielectric layer and the conductive layer adjacent to each other may be understood as:
a layer adjacent to the conductive layer is a dielectric layer, and a layer adjacent to the dielectric layer is a conductive layer.

That is, layers above and under a conductive layer are dielectric layers, and layers above and under a dielectric layer are conductive layers.

When the at least one groove-shaped support is a plurality of groove-shaped supports, the plurality of groove-shaped supports are electrically connected to each other. In one implementation, the plurality of groove-shaped supports are physically connected (for example, in a top view, the plurality of groove-shaped supports form a "#"-shaped or grid-shaped component). In another implementation, the plurality of groove-shaped supports are physically separated, and at this time, bottoms of the plurality of groove-shaped supports may be electrically connected, so that the plurality of groove-shaped supports may serve as a conductive layer (i.e., the first conductive layer), and the first conductive layer is used for an electrode plate (which may also be referred to as an electrode layer) of the capacitor 100.

In an embodiment, as shown in FIG. 1, the at least one groove-shaped support may be four groove-shaped supports, such as the four groove-shaped supports 1611 shown in FIG. 1; the at least one dielectric layer may be two dielectric layers, such as dielectric layers 162 and 164 shown in FIG. 1; and the at least one second conductive layer may be two conductive layers, such as conductive layers 163 and 165 shown in FIG. 1.

It should be noted that, in the embodiment of the present application, a dimension of a cross section of the groove-shaped support is not limited. For example, the groove-shaped support may be a hole with a small difference between length and width in a cross section, or a trench with a large difference between length and width, or may further be a 3D structure in a shape of a pillar (Pillar) or wall (Wall). Here, the cross section may be understood as a section parallel to an opening of the groove-shaped support. Of course, the embodiment of the present application does not specifically limit a direction of the opening of the groove-shaped support, which may be for example, vertical or inclined.

In some embodiments of the present application, the dielectric layer in the laminated structure 160 may include at least one of following layers:
a silicon oxide layer, a silicon nitride layer, a silicon oxynitride layer, a metal oxide layer, a metal nitride layer and a metal oxynitride layer.

That is, a material of the dielectric layer in the laminated structure 160 may be silicon oxide, silicon nitride, silicon oxynitride, metal oxide, metal nitride and metal oxynitride, or the like, such as silicon dioxide, silicon nitride, or high dielectric constant materials including aluminum oxide, hafnium oxide, zirconium oxide, titanium dioxide, Y₂O₃, La₂O₃, HfSiO₄, LaAlO₃, SrTiO₃, LaLuO₃, or the like; and it may also be the foregoing one material or a combination of the plurality of materials. A specific material and a layer thickness of the dielectric layer may be adjusted according to a capacitance value, a frequency characteristic and a loss and other requirements of a capacitor. Of course, the dielectric layer in the laminated structure 160 may also include some other material layers having high dielectric constant characteristics, which is not limited in the embodiment of the present application.

In some embodiments of the present application, a conductive layer (for example, the first conductive layer or the laminated structure 160) may include at least one of following layers:
a heavily doped polysilicon layer, a carbon-based material layer, a metal layer, a titanium nitride layer and a tantalum nitride layer.

In other words, a material of the conductive layer in the laminated structure 160 may be heavily doped polysilicon, carbon materials, or various metals such as aluminum, tungsten, copper, titanium (Ti), tantalum (Ta), platinum (Pt), ruthenium (Ru), iridium (Ir), rhodium (Rh), or the like, or a low-resistivity compound such as titanium nitride or tantalum nitride, or a laminated layer or combination of the foregoing several conductive materials.

Continuing to refer to FIG. 1, in the embodiment of the present application, four groove-shaped supports 1611 of which bottoms are electrically connected are used as a layer of electrode plate, and the dielectric layer 162 and the conductive layer 163 are formed by lamination on the four groove-shaped supports 1611 of which bottoms are electrically connected, which may not only increase a surface area of the capacitor, but also increase laminated density of the laminated structure since the electrode plate is used as a support of the laminated structure, thereby increasing the capacitance density of the capacitor. In addition, by setting the groove-shaped support with high density and a high depth-to-width ratio, the surface area and laminated density may be further improved.

In addition, the first conductive layer is used as a layer of electrode plate, it may be used to form a capacitor together with the dielectric layer 162 and the conductive layer 163; and the conductive layer 163, the dielectric layer 164 and the conductive layer 165 may be used to form another capacitor. Further, the conductive layer 163 is electrically connected to one electrode, and the first conductive layer and the conductive layer 165 are electrically connected to the other electrode, so that two capacitors are connected in parallel, and thus a capacitor with a large capacitance value may be obtained.

In summary, a capacitor is formed using a laminated structure that a conductive layer and a dielectric layer are alternately stacked, so that a larger capacitance value may be obtained in a case of a smaller device size, and thus capacitance density of the capacitor could be improved. In addition, the laminated structure is produced by using at least one groove-shaped support, laminated density of the laminated structure could be improved, and the capacitance value of the capacitor could be further increased, so that the capacitance density of the capacitor could be improved.

The interconnection structure 190 is configured to at least connect the first electrode 1111 and the second electrode 1112 to two adjacent conductive layers respectively, to ensure that the capacitor 100 can accommodate charges.

The two adjacent conductive layers may be understood as:
two conductive layers adjacent to one dielectric layer, that is, a conductive layer that is in contact with an upper surface of a dielectric layer and a conductive layer that is in contact with a lower surface of the dielectric layer.

In addition, at least connecting the first electrode 1111 and the second electrode 1112 to two adjacent conductive layers respectively may be understood as:
a conductive layer connected to the first electrode 1111 and a conductive layer connected to the second electrode 1112 are two adjacent conductive layers.

For example, the interconnection structure 190 is configured to electrically connect the first electrode 1111 to some or all odd-numbered conductive layer(s) in the laminated structure 160, and the second electrode 1112 is electrically connected to some or all even-numbered conductive layer(s) in the laminated structure 160, so as to connect a plurality of capacitors in the laminated structure 160 in parallel to the greatest extent.

It should be noted that in the embodiment of the present application, an order of the conductive layers involved may be an order from one side of the laminated structure 160 to the other side thereof, for example, an order from top to bottom or an order from bottom to top. For ease of description, description will be made by an example of an order from bottom to top.

For example, in a structure shown in FIG. 1, the conductive layers 1611, 163, and 165 are the first to third conductive layers, respectively. Odd-numbered conductive layers among the conductive layers 1611, 163 and 165, i.e., the first conductive layer and the third conductive layer, may be electrically connected to the first electrode 1111 through the interconnection structure 190, and an even-numbered conductive layer among the conductive layers 1611, 163 and 165, i.e., the second conductive layer, may be electrically connected to the second electrode 1112 through the interconnection structure 190.

A material of the interconnection structure 190 may adopt various conductive materials, which may be the same as or different from the material of the conductive layer in the laminated structure 160. For example, it may be titanium nitride and a metal of tungsten.

In some embodiments of the present application, the capacitor 100 may further include an insulating structure configured to clad the laminated structure 160 to protect the laminated structure 160 and reduce interference between the laminated structure 160 and other external circuits.

It should be noted that the insulating structure cladding the laminated structure 160 may be understood as:
the insulating structure at least covers two sides of the laminated structure 160, which is not limited to the fact that the insulating structure needs to completely clad the laminated structure 160.

In some embodiments of the present application, continuing to refer to FIG. 1, the insulating structure may include a first insulating layer 140 and a second insulating layer 180.

An upper surface of the first insulating layer 140 may extend downward to form a groove structure, the at least one groove-shaped support is disposed in the groove structure of the first insulating layer 140, and the at least one second conductive layer in the laminated structure 160 is provided with at least one first step at an opening edge of the groove structure of the first insulating layer 140.

A material of the first insulating layer 140 may be an organic polymer material, including polyimide (Polyimide), parylene (Parylene), benzocyclobutene (BCB), or the like, it may also be some inorganic materials, including spin on glass (Spin on glass, SOG), undoped silicon glass (Undoped Silicon Glass, USG), boro-silicate glass (Boro-silicate glass, BSG), phospho-silicate glass (phospho-silicate glass, PSG), boro-phospho-silicate glass (Boro-phospho-silicate glass, BPSG), silicon oxide synthesized by tetraethyl orthosilicate (Tetraethyl Orthsilicate, TEOS), silicon oxide, silicon nitride and ceramic; and it may also be a combination of the foregoing materials.

With reference to FIG. 1, the dielectric layer 162, the conductive layer 163 and the dielectric layer 164 are aligned, and a step is formed between the conductive layer 165 and the dielectric layer 164.

Of course, the step described in FIG. 1 is only an example of the present application, which should not be understood as a limitation to the present application

For example, in other alternative embodiments, the dielectric layer 162 and the conductive layer 163 may be aligned, and the dielectric layer 164 and the conductive layer 165 are aligned, and a step is formed between the conductive layer 163 and the dielectric layer 164.

The second insulating layer 180 covers the first insulating layer 140 and the laminated structure 160. A material of the second insulating layer 180 may be the same as or different from that of the first insulating layer 140, which is not specifically limited in the present application.

At this time, the interconnection structure 190 may include a first via 181 and at least one second via 182.

The first via 181 penetrates the first insulating layer 140, the second insulating layer 180 and an insulating layer 130, and is configured to electrically connect the first electrode 1111 to the first conductive layer including the groove-shaped support 1611. It should be understood that the capacitor 100 may not include the insulating layer 130, and at this time, the first via 181 only needs to penetrate the first insulating layer 140 and the second insulating layer 180.

The at least one second via 182 is disposed above the at least one first step and penetrates the second insulating layer 180, and the interconnection structure 190 is electrically connected to some or all conductive layer(s) in the at least one second conductive layer in the laminated structure 160 through the at least one second via 182.

It should be noted that since the conductive layer 163 and the dielectric layer 164 are aligned in FIG. 1, the second via 182 on the left side needs to penetrate the second insulating layer 180 and the dielectric layer 164. However, the present application is not limited thereto.

For example, in other alternative embodiments, the dielectric layer 162 and the conductive layer 163 are aligned, and at this time, the second via 182 on the left side may only penetrate the second insulating layer 180.

The first via 181 and the at least one via 182 may be filled with a conductive material that is the same as or different from the material of the conductive layer in the laminated structure 160, or may also be provided with wiring layers for electrically connecting the conductive layers in the laminated structure 160, which is not specifically limited in the present application.

Continuing to refer to FIG. 1, in some embodiments of the present application, the capacitor 100 may further include a substrate 110 disposed under the laminated structure 160 to support the laminated structure 160.

The substrate 110 may be a low-resistivity monocrystalline silicon wafer, or may be a semiconductor substrate, a glass substrate or an organic substrate provided with a low-resistivity conductive layer on a surface to ensure conductivity of the foregoing plurality of groove-shaped supports. A material of the semiconductor substrate includes, but is not limited to, silicon, germanium, or III-V elements (silicon carbide (SiC), gallium nitride (GaN), gallium arsenide (GaAs), or the like), or a combination of the foregoing different materials. The semiconductor substrate may further include an epitaxial layer structure, such as a silicon-on-insulator (silicon-on-insulator, SOI) structure, for insulating the substrate. The substrate 110 may be a whole wafer or a portion cut from the wafer.

The low-resistivity conductive layer may be heavily doped silicon, metal, TiN, TaN, carbon or conductive organic matter. The low-resistivity conductive layer may be a conductive layer with a resistivity lower than a preset threshold value. The preset threshold value is set so that the plurality of groove-shaped supports 1611 serve as a conductive layer of the capacitor 100 after bottoms of the plurality of groove-shaped supports 1611 in the laminated structure 160 are electrically connected.

In an example that a surface of the substrate 110 is provided with a conductive layer, with reference to FIG. 1, the capacitor 100 may include a third conductive layer 120 disposed between the substrate 110 and the laminated structure 160, and the third conductive layer 120 at least covers part of the substrate.

The third conductive layer 120 is configured to electrically connect the bottoms of the four groove-shaped supports 1611 shown in FIG. 1, so that the four groove-shaped supports 1611 may be used as the first conductive layer of the capacitor, to improve the laminated density of the laminated structure 160.

Continuing to refer to FIG. 1, in some embodiments of the present application, the capacitor 100 may further include a fourth insulating layer 130 disposed between the third conductive layer 120 and the laminated structure 160; and the fourth insulating layer 130 may be provided with at least one via, so that a bottom of the at least one groove-shaped support 1611 included in the laminated structure 160 may be disposed in the at least one via of the fourth insulating layer 130, thereby further ensuring the insulation between the third conductive layer 120 and the conductive layer 163, and thus performance of the capacitor 100 is ensured. For example, the bottom of the at least one groove-shaped support 1611 included in the laminated structure 160 may be disposed in the at least one via of the fourth insulating layer 130 in a one-to-one correspondence manner.

It should be understood that FIG. 1 is only an example of the capacitor of the present application and should not be understood as a limitation to the present application.

FIG. 2 is another schematic block diagram of a capacitor 200 according to an embodiment of the present application.

Referring to FIG. 2, the capacitor 200 may include a first electrode 281, a second electrode 282, a laminated structure 250 and an interconnection structure 290.

The laminated structure 250 may include four groove-shaped supports 2511, a dielectric layer 252, a conductive layer 253, a dielectric layer 254 and a conductive layer 255.

Continuing to refer to FIG. 2, the capacitor 200 may further include a substrate 210 to support the laminated structure 250 and electrically connect the four groove-shaped supports 2511. Further, the capacitor 200 may further include a conductive layer 220 to ensure the conductivity of the four groove-shaped supports 2511. Further, the capacitor 200 may further include an insulating layer 230 to further ensure insulation between the conductive layers 220 and 253, and thus performance of the capacitor 200 is ensured.

It should be understood that, since the capacitor 200 can be understood as a variation structure of the capacitor 100, in order to avoid repetition, the corresponding relevant description is omitted here, such as materials of the corresponding conductive layer and dielectric layer, and the corresponding working principles.

A structure of the capacitor 200 will be described in detail below.

Continuing to refer to FIG. 2, the capacitor 200 may include a third insulating layer 250 configured to clad the laminated structure 160 to protect the laminated structure 160 and reduce interference between the laminated structure 160 and other external circuits.

In some embodiments of the present application, continuing to refer to FIG. 2, the capacitor 100 may further include a third insulation 270. The third insulating layer 270 clads the laminated structure 250, and the at least one second conductive layer (i.e., conductive layers 2511, 252 and 255) in the laminated structure 250 is provided with at least one second step in the third insulating layer 270.

With reference to FIG. 2, the at least one second conductive layer in the laminated structure 250 is provided with the at least one second step at a bottom of the third insulating layer 270 close to the groove-shaped support 2511. For example, the at least one second conductive layer in the laminated structure 250 is provided with the at least one second step at the bottom of the third insulating layer 270 close to the groove-shaped support 2511 in a one-to-one corresponding manner.

At this time, the interconnection structure 290 may include a third via 271 and at least one fourth via 272.

The third via 271 penetrates the third insulating layer 270, and is configured to electrically connect the first electrode 281 to a first conductive layer including the groove-shaped support 2511 through the conductive layer 230.

The at least one fourth via 272 is disposed above the at least one second step and penetrates the third insulating layer 270, and the interconnection structure 290 may be electrically connected to some or all conductive layer(s) in the at least one second conductive layer in the laminated structure 250 through the at least one second step.

Similar to the capacitor 100, the embodiment of the present application does not limit the implementation manner of the step of at least one dielectric layer in the laminated structure 250.

For example, as shown in FIG. 2, the dielectric layer 252 and the conductive layer 253 are aligned, the dielectric layer 254 and the conductive layer 255 are aligned, and the conductive layer 253 and the dielectric layer 254 form a step. However, in other embodiments, the conductive layer 253 is aligned with the dielectric layer 254, and the dielectric layer 254 and the conductive layer 255 form a step.

That is, at a position of the at least one second step, if an upper surface of the second step is an upper surface where a conductive layer is located, the fourth via 272 only needs to penetrate the third insulating layer 270; or if an upper surface of the second step is a dielectric layer, the fourth via 272 needs to penetrate both the third insulating layer 270 and the dielectric layer above a conductive layer.

It should also be understood that a preferred embodiment of the present application has been described in detail above with reference to the accompanying drawings. However, the present application is not limited to the specific details of the foregoing embodiment. Many simple modifications may be made to the technical solution of the present application within the scope of the technical concept of the present application, and these simple modifications all fall within the scope of protection of the present application.

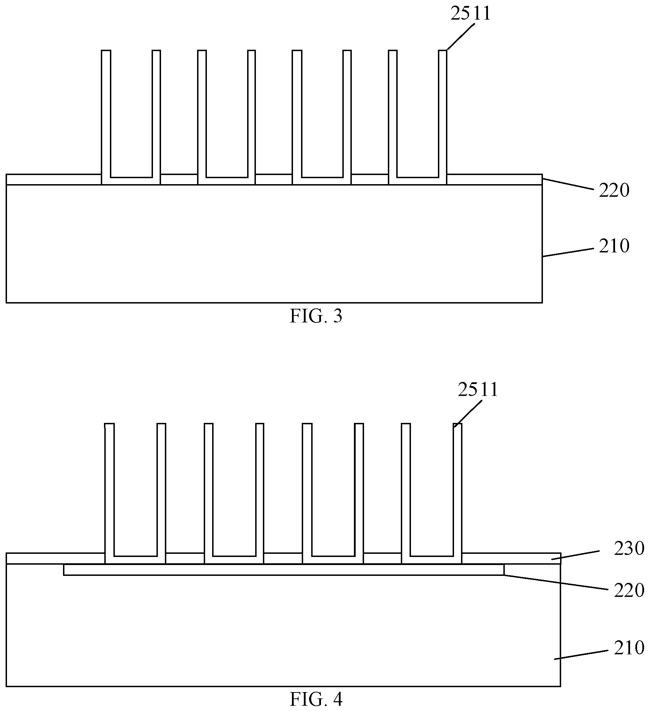

FIGS. 3 and 4 are partial schematic structural diagrams of the capacitor 200 after simple modification.

It is assumed that the capacitor 200 includes a substrate 210 and a third conductive layer 220, at this time, a groove-shaped support 2511 in the laminated structure 250 may be directly electrically connected to the third conductive layer 220, however the connection manner between the groove-shaped support 2511 and the third conductive layer 220 is not limited in the present application. For example, in FIG. 2, a bottom of the groove-shaped support 2511 in the laminated structure 250 is in direct contact with an upper surface of the third conductive layer 220. For another example, in FIG. 3, the groove-shaped support 2511 in the laminated structure 250 may be embedded in the third conductive layer 220 or penetrate the third conductive layer 220 to improve stability. At this time, the groove-shaped support 2511 may or may not be in direct contact with the substrate 210, which is not specifically limited in the present application.

For example, referring to FIG. 3, the third conductive layer 220 may be provided with at least one fifth via penetrating the third conductive layer 220, and the bottom of the groove-shaped support 251 in the laminated structure 250 may be disposed in the at least one fifth via.

Further, referring to FIG. 4, it is assumed that the capacitor 200 includes a substrate 210 and a third conductive layer 220, at this time, an upper surface of the substrate 210 extends downward to form a groove, and the third conductive layer 220 is disposed in the groove of the substrate 210.

In the embodiment of the present application, a laminated structure that a conductive layer and an insulating layer are alternately stacked is adopted, so that a larger capacitance value may be obtained in a case of a smaller device size, and thus capacitance density of the capacitor could be improved. Further, the groove-shaped support of the first conductive layer is used as a frame to form the laminated structure, which could improve laminated density of the laminated structure and further improve the capacitance density of the capacitor.

It should be understood that the capacitors in FIGS. 1 to 4 are only examples and should not be understood as a limitation to the present application.

For example, the number of laminated layers and the number of groove-shaped supports in the laminated structure included in the capacitor are not limited to those shown in the capacitors in FIGS. 1 to 4, and may be determined according to actual needs.

The present application also provides a method for producing a capacitor 100 and a capacitor 200.

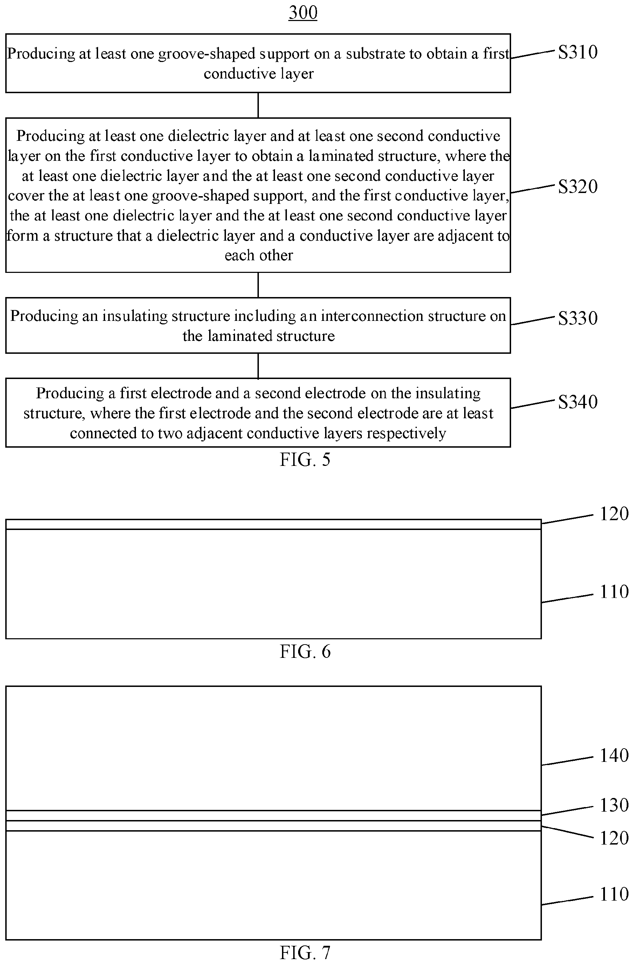

FIG. 5 is a schematic process flow chart of a method 300 for producing a capacitor according to an embodiment of the present application.

As shown in FIG. 5, the method 300 may include:
S310, producing at least one groove-shaped support on a substrate to obtain a first conductive layer;
S20, producing at least one dielectric layer and at least one second conductive layer on the first conductive layer to obtain a laminated structure, where the at least one dielectric layer and the at least one second conductive layer cover the at least one groove-shaped support, and the first conductive layer, the at least one dielectric layer and the at least one second conductive layer form a structure that a dielectric layer and a conductive layer are adjacent to each other;
S330, producing an insulating structure including an interconnection structure on the laminated structure; and
S340, producing a first electrode and a second electrode on the insulating structure, where the first electrode and the second electrode are at least connected to two adjacent conductive layers respectively.

The production includes the following: first, a groove-shaped support with an upward opening is provided on a surface of a substrate. Then, a first capacitor is provided on the cup-shaped support, and includes a first electrode plate layer, a first dielectric layer and a second electrode plate layer, where the first dielectric layer electrically isolates the first electrode plate layer from the second electrode plate layer. Then, a second capacitor is provided on the first capacitor, and includes a second electrode plate layer, a second dielectric layer and a third electrode plate layer, where the second dielectric layer electrically isolates the second electrode plate layer from the third electrode plate layer. Finally, an interconnection structure and a pad are provided, where at least one pad is electrically connected to the first electrode plate layer and the third electrode plate layer, and the at least one pad is electrically connected to the second electrode plate layer.

In other words, the method 300 mainly includes the following steps.

Step 1, a substrate is selected.

Step 2, first, a trench or a hole-shaped mold is formed on an upper surface of the substrate by deposition and photolithography processes, or a trench or a hole-shaped mold is formed on an upper surface of the substrate by an electroplating process; then, a groove-shaped (or cup-shaped) support conformal to an inner wall of the mold is produced on the upper surface of the substrate by deposition, surface planarization and etching (or corrosion) processes. Preferably, the groove-shaped support is made of a conductive material. A bottom of the groove-shaped support is electrically connected to a low-resistivity conductive region of the substrate.

Step 3, a first capacitor is provided on the support, and includes a first electrode plate layer, a first dielectric layer and a second electrode plate layer.

Step 4, a second capacitor is provided on the first capacitor, and includes a second electrode plate layer, a second dielectric layer and a third electrode plate layer.

Step 5, an interconnection structure and a pad are produced. At least one pad is electrically connected to the first electrode plate layer (and/or the substrate) and the third electrode plate layer, and the at least one pad is electrically connected to the second electrode plate layer.

It should be understood that the etching process may include at least one of following processes:
a dry etching process, a wet etching process, or a laser etching process.

Further, the dry etching (dry etching) process may include at least one of following etching processes: reactive ion etching (reactive ion etching), plasma etching (plasma etching), ion beam etching (ion beam etching), or the like. Preferably, an etching speed may be changed by changing a mixing ratio of etching gases. A chemical raw material of the wet etching process may include, but is not limited to, an etching solution containing hydrofluoric acid. In some embodiments of the present application, an etched shape, flatness of a bottom surface, or the like could be effectively ensured using an etching method of combining dry etching and wet etching or a method of combining laser etching and wet etching.

The deposition process includes, but is not limited to:
a physical vapor deposition (Physical Vapor Deposition, PVD) process and/or a chemical vapor deposition (Chemical Vapor Deposition, CVD) process. For example, thermal oxidation, plasma enhanced chemical vapor deposition (Plasma Enhanced Chemical Vapor Deposition, PECVD), low pressure chemical vapor deposition (Low Pressure Chemical Vapor Deposition, LPCVD), atomic layer deposition (Atomic layer deposition, ALD), spin coating or spray coating, or the like.

A method for producing the capacitor 100 will be described in detail below.

In some embodiments of the present application, the foregoing S310 may include some or all of the following steps:
step 1, forming a first insulating layer on a substrate;
step 2, forming a first groove penetrating the first insulating layer;
step 3, filling the first groove with a first material;
step 4, forming at least one second groove penetrating the first material;
step 5, producing a conductive layer conformal to an inner wall of the at least one second groove on an upper surface of the at least one second groove;
step 6, filling the at least one second groove with a second material;
step 7, removing the second material and the conductive layer that are above the first insulating layer; and
step 8, removing the second material in the at least one second groove to form the first conductive layer.

In some embodiments of the present application, the foregoing S320 may include some or all of the following steps:
step 9, producing the at least one dielectric layer and the at least one second conductive layer on the first conductive layer; and
step 10, forming at least one first step of the at least one dielectric layer and the at least one second conductive layer at an opening edge of the first groove to obtain the laminated structure.

In some embodiments of the present application, the foregoing S330 may include some or all of the following steps:
step 11: producing a second insulating layer on the laminated structure and the first insulating layer;
step 12, forming a first via penetrating the first insulating layer and the second insulating layer;
step 13, forming at least one second via penetrating the second insulating layer above the at least one first step; and
step 14, filling the first via and the at least one second via with a conductive material.

In some embodiments of the present application, the foregoing S340 may include some or all of the following steps:
step 15, forming the first electrode above the first via and/or above the second via corresponding to some or all odd-numbered conductive layer(s) in the laminated structure; and
step 16, forming the second electrode above the second via corresponding to some or all even-numbered conductive layer(s) in the laminated structure.

A method for producing the capacitor 100 will be described in detail below with reference to FIGS. 6 to 19.

A substrate is selected, and the substrate 110 may be a low-resistivity monocrystalline silicon wafer, or may be a semiconductor substrate, a glass substrate or an organic substrate provided with a low-resistivity conductive layer on a surface. For ease of description, the following description will take the substrate as a silicon wafer as an example.

After selecting the silicon wafer, doping is performed by ion implantation and annealing or by diffusion, and then a low-resistivity conductive layer 120 is formed on a surface of a silicon wafer 110 to form a structure shown in FIG. 6. The conductive layer 120 may cover an entire upper surface of the substrate 110 or part of an upper surface of the substrate 110, which is not specifically limited in the present application. For ease of description, the method 300 will be described below by taking an example that the conductive layer 120 may cover an entire upper surface of the substrate 110. Preferably, a doping type of the conductive layer is opposite to an original doping type of the substrate.

An insulating layer 130 and a first molding material (molding material) 140 are deposited on the structure shown in FIG. 6 to form a structure shown in FIG. 7.

It should be noted that the insulating layer 130 and the insulating layers mentioned below may be made of the insulating material mentioned above, which will not be repeatedly described here to avoid repetition. The first molding material 140 may include, but is not limited to, polysilicon, amorphous silicon, silicon oxide, silicon nitride, silicon oxynitride, TEOS, or silicon-containing glass (such as USG, BSG, PSG, BPSG), or spin-coated SOG or an organic material.

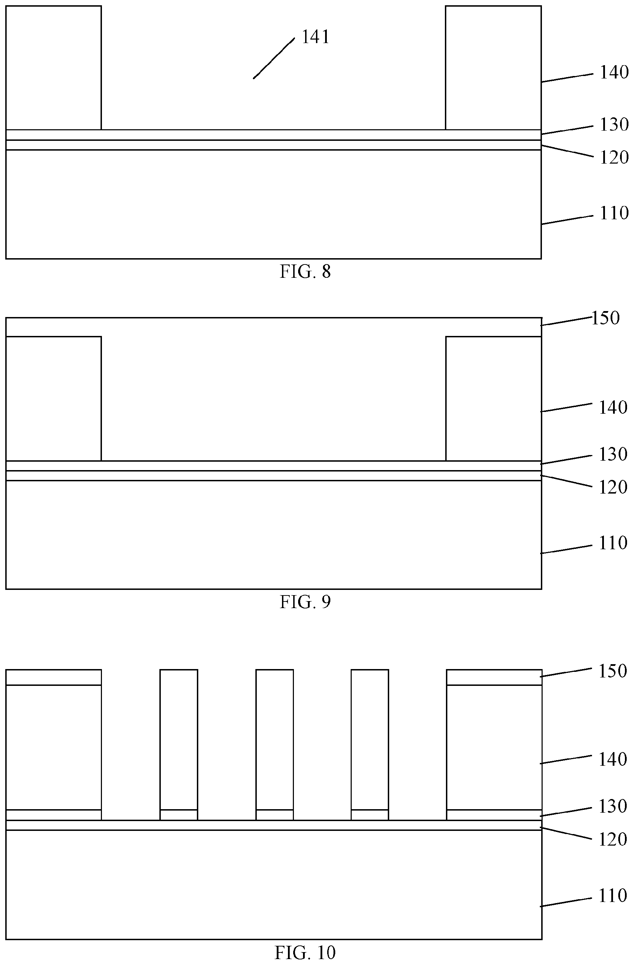

On the structure shown in FIG. 7, an upper surface of the first molding material 140 extends downward to form a groove 141 with an upward opening to expose the insulating layer 130, thereby forming a structure shown in FIG. 8.

On the structure shown in FIG. 8, the groove 141 of the first molding material 140 is filled with a second molding material 150 to form a structure shown in FIG. 9. Preferably, the second molding material 150 and the first molding material 140 may be different, so that the second molding material 150 may be selectively removed. Of course, the second molding material 150 may also be selectively removed by other manners, which is not specifically limited in the present application.

On the structure shown in FIG. 9, an array of grooves (such as four grooves) is produced using a photolithography process combined with an etching process, and each groove in the array of grooves penetrates the first molding material 140, the second molding material 150 and the insulating layer 130 to expose the conductive layer 120, thereby forming a structure shown in FIG. 10.

It should be noted that in the structure shown in FIG. 10, the number of grooves in the array of grooves is only an example of the present application, and should not be understood as a limitation to the present application. For example, the number of grooves in the array of grooves may be greater than 4 or less than 4, such as 0.

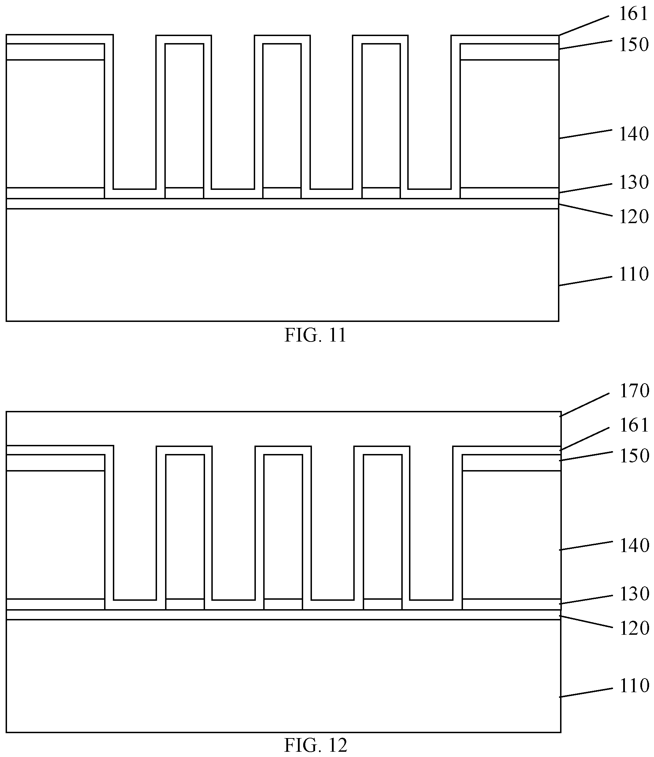

On the structure shown in FIG. 10, a conductive layer 161 is deposited on an upper surface (including a sidewall and a bottom) of the array of grooves to form a structure shown in FIG. 11.

It should be noted that the conductive layer 161 and the conductive layers mentioned below may be made of the conductive material mentioned above, which is not repeatedly described here to avoid repetition. For example, the conductive layer 161 may be made of heavily doped polysilicon deposited by an LPCVD process, metal such as TiN, TaN or Pt deposited by an ALD process, or a carbon material deposited by a CVD process.

On the structure shown in FIG. 11, the array of grooves is filled with a third molding material 170 to form a structure shown in FIG. 12. Preferably, the third molding material 170 and the first molding material 140 may be different, so that the third molding material 170 may be selectively removed. Of course, the third molding material 170 may also be selectively removed by other manners, which is not specifically limited in the present application.

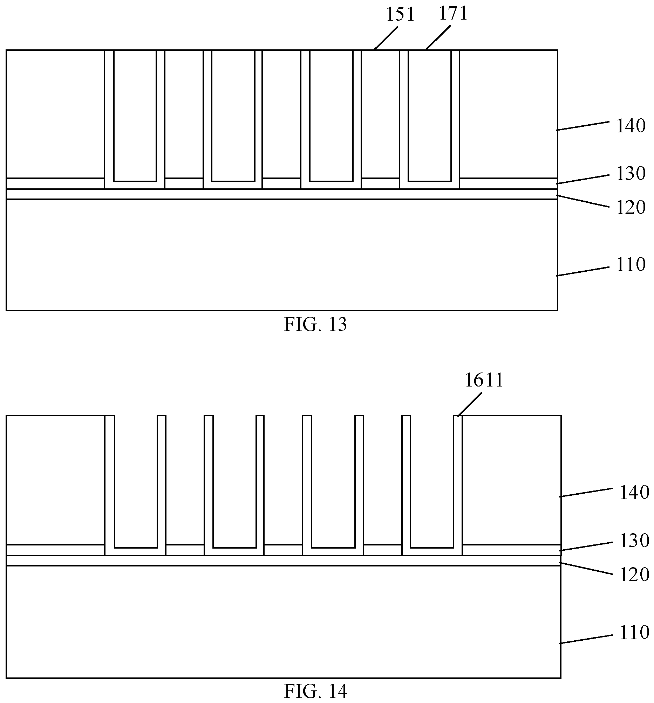

On the structure shown in FIG. 12, the third molding material 170 and the conductive layer 161 that are above the first molding material 140 are removed by a surface planarization process to obtain a groove-shaped (also referred to as cup-shaped) structure with an upward opening, which is between the first molding material 140 (or the remaining second molding material 151) and the remaining third molding material 171, to form a structure shown in FIG. 13.

On the structure shown in FIG. 13,the remaining second molding material 151 and the remaining third molding material 171 are removed by using a selective etching (or corrosion) process, and the first molding material 140 and the insulating layer 130 remain; that is, the foregoing groove-shaped structure is converted into a groove-shaped support 1611, and a bottom of the groove-shaped support 1611 is embedded into the insulating layer 130 and is in contact with the conductive layer 120 on the surface of the substrate 110, thereby forming a structure shown in FIG. 14.

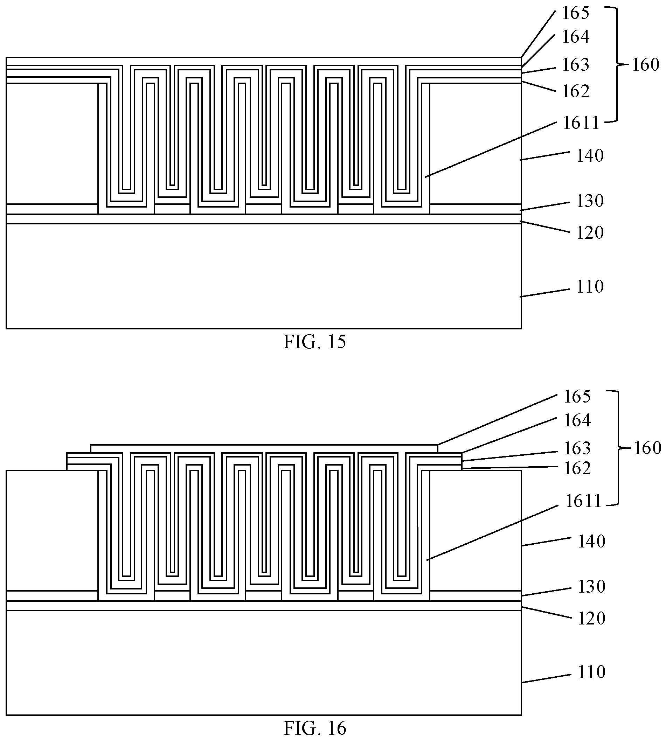

On the structure shown in FIG. 14, a dielectric layer 162, a conductive layer 163, a dielectric layer 164 and a conductive layer 165 are sequentially deposited, to form a structure shown in FIG. 15.

On the structure shown in FIG. 15, a step of the conductive layer 163 and the conductive layer 165 are formed using a multi-step photolithography process combined with an etching process, to form a structure shown in FIG. 16.

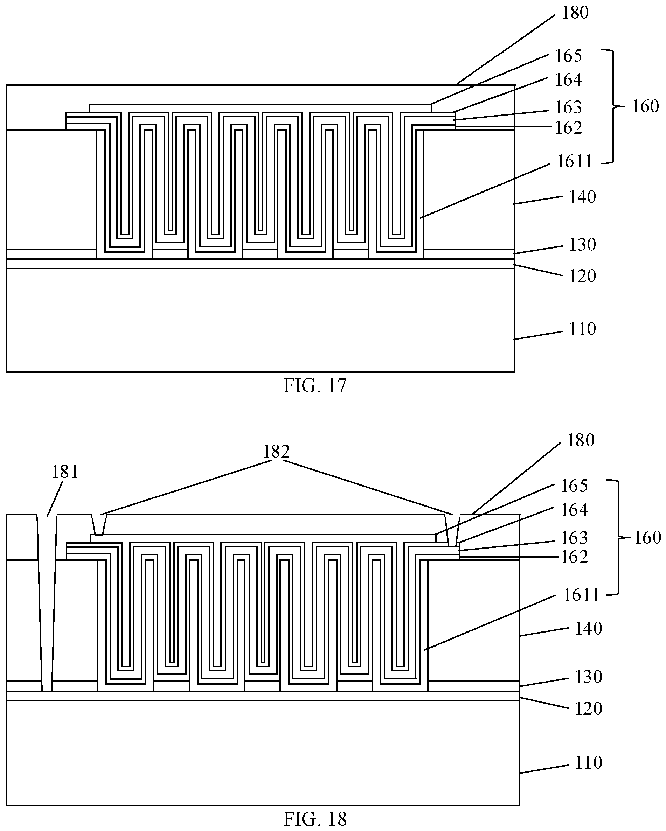

On the structure shown in FIG. 16, an insulating layer 180 is deposited to cover the step of the conductive layer 163 and the conductive layer 165, to form a structure shown in FIG. 17.

On the structure shown in FIG. 17, by using a photolithography process and an etching process, a first via 181 is provided to expose the conductive layer 120 on the surface of the substrate 110, and at least one second via 182 is provided to expose the conductive layer 163 and the conductive layer 165, thereby forming a structure shown in FIG. 18.

It should be noted that the first via 181 and the at least one second via 182 may be filled with a conductive material, or may be provided with a wiring layer for electrical connection. For ease of explanation, a method for producing a capacitor will be described below by taking an example that the first via 181 and the at least one second via 182 may be filled with a conductive material. In addition, in FIG. 18, the second via 182 on the right needs to penetrate the insulating layer 180 and the dielectric layer 163, however the present application is not limited thereto. For example, it is assumed that the dielectric layer 163 and the conductive layer 165 are aligned, the second via 182 on the right only needs to penetrate the insulating layer 180.

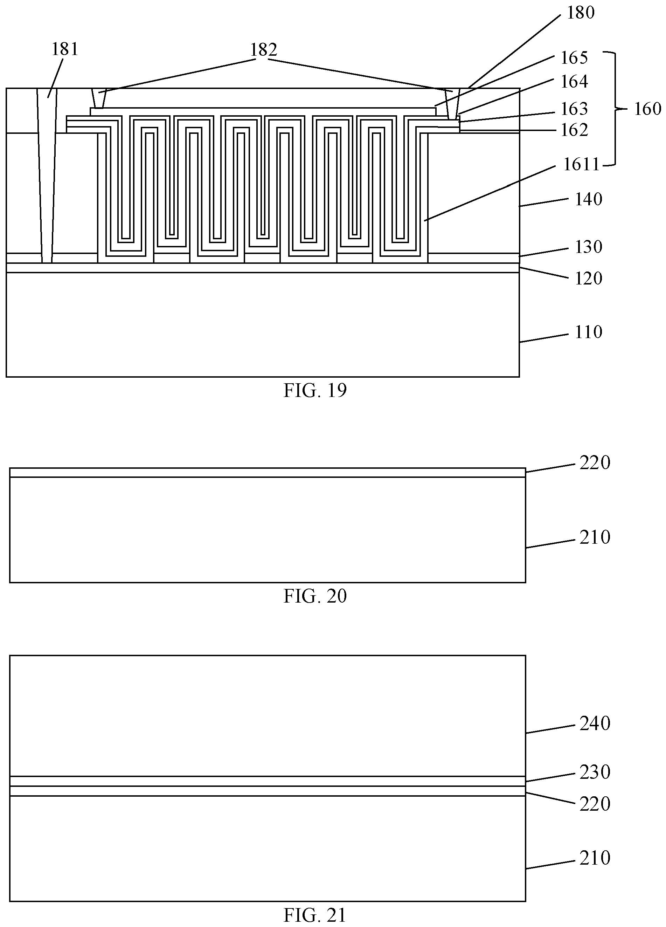

On the structure shown in FIG. 18, the first via 181 and at least one second via 182 are filled with a low-resistivity conductive material, and the redundant conductive material above the insulating layer 180 is ground away by a surface planarization process to obtain independent conductive channels, to form a structure shown in FIG. 19.

On the structure shown in FIG. 19, a conductive material is deposited on the insulating layer 180, and then a pattern is formed by photolithography to form a pad. One pad is electrically connected to the conductive layer 163, the other pad is electrically connected to the conductive layer 165, and is electrically connected to the groove-shaped support 1611 through the conductive layer 120, finally forming the structure shown in FIG. 1.

It should be noted that the pad (pad) may be made of metal. The pad (pad) may be made of copper or aluminum, and may also include a low-resistivity Ti, TiN, Ta or TaN layer between the pad and an ILD as an adhesion layer and/or a barrier layer; and it may also include some metal layers on a surface of the pad, which are, for example, made of Ni, Pd, Au, Sn and Ag, for subsequent wire bonding or welding process.

It should be understood that FIGS. 6 to 19 are only an example of the present application, and should not be understood as a limitation to the present application.

For example, in other alternative embodiments, a process of producing the conductive layer 120 and/or the insulating layer 130 may be directly omitted. That is, the first molding material 130 is directly deposited on the substrate 110 or the conductive layer 120.

For another example, in other alternative embodiments, on the structure shown in FIG. 9, an array of grooves (e.g., four grooves) may be produced using a photolithography process combined with an etching process, and each groove in the array of grooves may penetrate the first molding material 140, the second molding material 150, the insulating layer 130 and the conductive layer 120 to expose the substrate 110. Further, each groove in the array of grooves may be embedded in the substrate 110.

A method for producing the capacitor 200 will be described in detail below.

In some embodiments of the present application, the foregoing S310 may include some or all of the following steps:
step 1: forming a third material on the substrate;
step 2, forming at least one third groove penetrating the third material;
step 3, producing a conductive layer conformal to an inner wall of the at least one third groove on an upper surface of the at least one third groove;
step 4, filling the at least one third groove with a fourth material;
step 5, removing the fourth material and the conductive layer that are above the third material; and
step 6, removing the third material and the fourth material above the substrate to form the first conductive layer.

In some embodiments of the present application, the foregoing S320 may include some or all of the following steps:
step 7, producing the at least one dielectric layer and the at least one second conductive layer on the first conductive layer; and
step 8, forming at least one second step of the at least one second conductive layer on the substrate to obtain the laminated structure.

In some embodiments of the present application, the foregoing S330 may include some or all of the following steps:
step 9, producing a third insulating layer on the laminated structure;
step 10, forming a third via penetrating the third insulating layer;
step 11, forming at least one fourth via penetrating the third insulating layer above the at least one second step; and
step 12, filling the third via and the at least one fourth via with a conductive material.

In some embodiments of the present application, the foregoing S340 may include some or all of the following steps:
step 13, forming the first electrode above the third via and/or above the fourth via corresponding to some or all odd-numbered conductive layer(s) in the laminated structure; and
step 14, forming the second electrode above the fourth via corresponding to some or all even-numbered conductive layer(s) in the laminated structure.

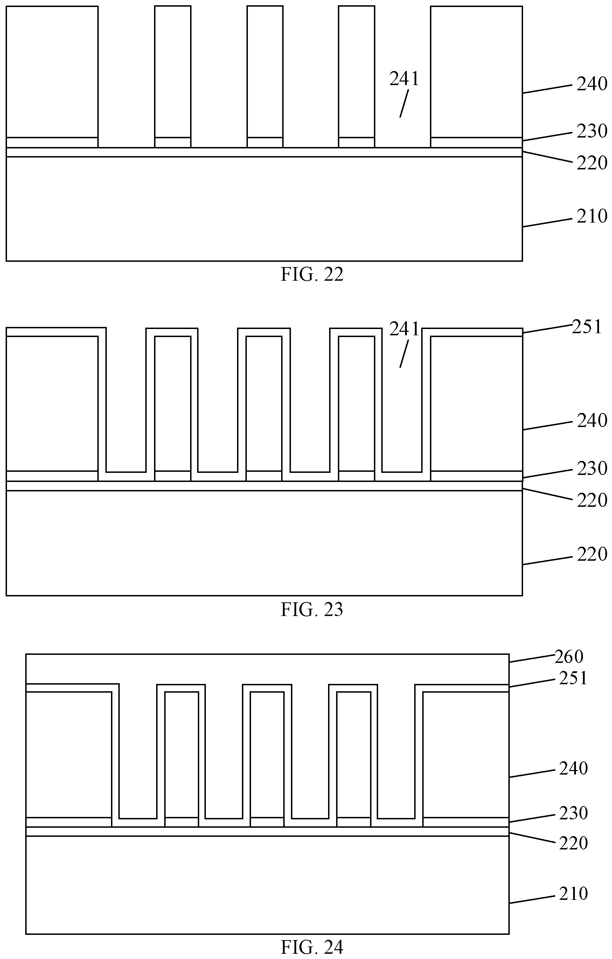

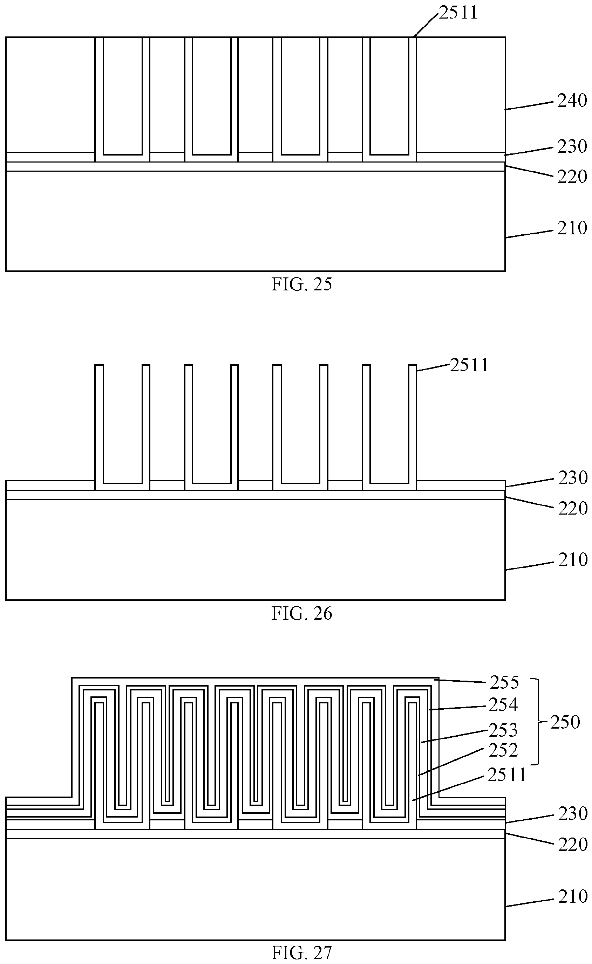

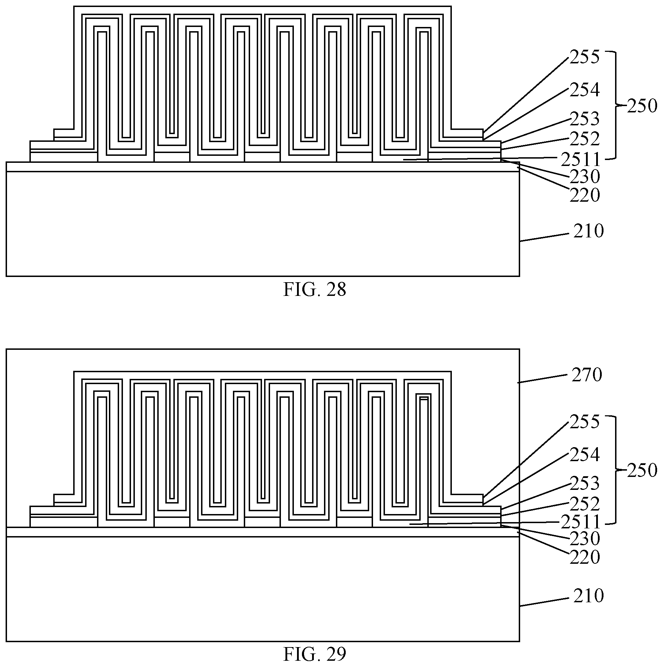

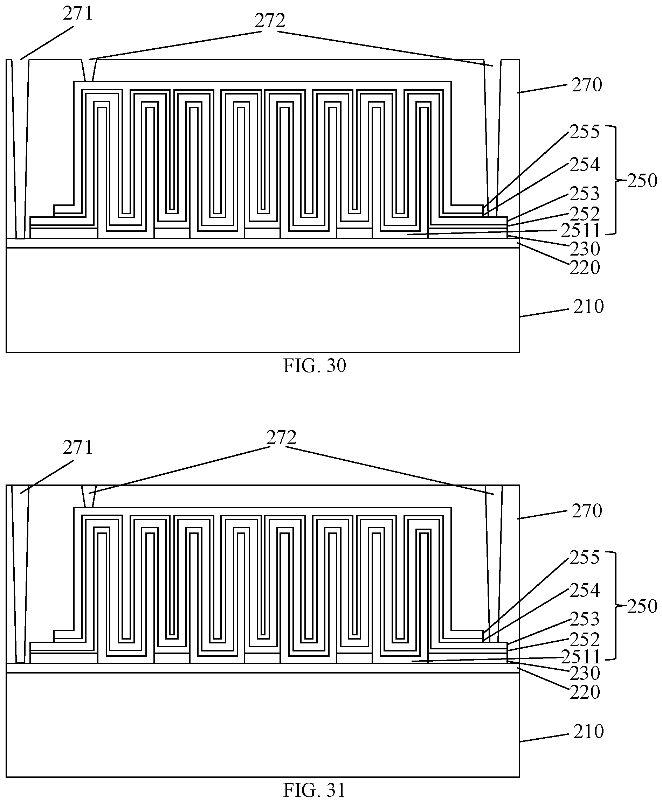

With reference to FIGS. 20 to 31, a substrate 210 is selected and a conductive layer 220is covered on the substrate 210, to form a structure shown in FIG. 20. An insulating layer 230 is covered on the conductive layer 220, and a fourth molding material 240 (which may be the same as or different from the foregoing first molding material) is covered on the insulating layer to form a structure shown in FIG. 21. By using a photolithography process, combined with an etching process (or corrosion process), an upper surface of the fourth molding material 240 extends downward to form at least one third groove 241 with an upward opening, which penetrates the fourth molding material 240, to form a structure shown in FIG. 22. A conductive layer 251 is deposited on an upper surface of the at least one third groove 241, to form a structure shown in FIG. 23. The at least one third groove is filled with a fifth molding material 260 (which may be the same as or different from the first molding material), to form a structure shown in FIG. 24. The fifth molding material 260 and the conductive layer 251 that are above the third material are removed using a photolithography process combined with an etching process, to form a structure shown in FIG. 25. By using a selective etching (or corrosion) process, the fourth molding material 240 and the fifth molding material 260 above the substrate are removed to form at least one groove-shaped support 2511, thereby obtaining a structure shown in FIG. 26. A dielectric layer 252, a conductive layer 253, a dielectric layer 254 and a conductive layer 255 are sequentially deposited, to form a structure shown in FIG. 27. A step of the conductive layer 253 and the conductive layer 255 are formed using a multi-step photolithography process combined with an etching process, to form a structure shown in FIG. 28. An insulating layer 270 is deposited on the conductive layer 255, the conductive layer 253 and the insulating layer 230, to form a structure shown in FIG. 29. By using a photolithography process and an etching process, a third via 271 is provided to expose the conductive layer 220 on the surface of the substrate 210, and at least one fourth via 272 is provided to expose the conductive layer 253 and the conductive layer 25, to form a structure shown in FIG. 30. The third via 271 and the at least one fourth via 272 are filled with a low-resistivity conductive material, and the redundant conductive material above the insulating layer 270 is ground away by a surface planarization process to obtain independent conductive channels, to form a structure shown in FIG. 31. A conductive material is deposited on the insulating layer 270, and then a pattern is formed by photolithography to form a pad, thereby obtaining the capacitor shown in FIG. 2.

It should be understood that FIGS. 20 to 30 are only an example of the present application, and should not be understood as a limitation to the present application

For example, in other alternative embodiments, a process of producing the conductive layer 220 and/or the insulating layer 230 may be directly omitted. That is, the first molding material 130 is deposited directly on the substrate 210 or the conductive layer 220.

For another example, in other alternative embodiments, in the structure shown in FIG. 22, the at least one third groove 241 may penetrate the conductive layer 220 or even be embedded in the substrate 210.

The present application further provides a capacitor produced according to the foregoing producing method.

It should also be understood that the method embodiments and the product embodiments may correspond to each other, and similar descriptions may refer to the product embodiments. Details will not be repeatedly described here for brevity.

It should also be understood that, each embodiment of the method 300 for producing the capacitor listed above may be executed by a robot or numerical control machine. The device software or process for executing the method 300 may execute the foregoing method 300 by executing the computer program code stored in the memory.

It shall be noted that each embodiment described in the present application and/or the technical features in each embodiment may be combined with each other arbitrarily in the case of no conflict, and the technical solutions obtained after combination should also fall into the protection scope of the present application.

It should be understood that sequence numbers of the foregoing processes do not mean execution sequences in various embodiments of the present application. The execution sequences of the processes should be determined according to functions and internal logic of the processes, and should not be construed as any limitation to the implementation processes of the embodiments of the present application.

An ordinary person skilled in the art may be aware that the various exemplary components described in conjunction with the embodiments disclosed herein can be implemented by electronic hardware or a combination of computer software and electronic hardware. Whether these functions are implemented in the form of hardware or software depends upon a particular application of the technical solutions and constraint conditions of design. A person skilled in the art may use different methods to implement the described functions for each particular application, but it should not be considered that the implementation goes beyond the scope of the present application.

In several embodiments provided by the present application, it should be understood that the disclosed integrated apparatus, the components in the integrated apparatus and the method for producing the integrated apparatus may be realized in other manners. For example, the embodiments of the integrated apparatus described above are only exemplary. For example, the division of layers is just a division of logical functions, and there may be other division manners for practical implementations. For example, multiple layers or devices may be combined or integrated, and for example, the upper plate and the active material layer may be combined into one layer. Or some features (such as the active material layer) may be omitted or not produced.

The foregoing descriptions are merely specific embodiments of the present application, however, the protection scope of the present application is not limited thereto, persons skilled in the art who are familiar with the art could readily think of variations or substitutions within the technical scope disclosed by the present application, and these variations or substitutions shall fall within the protection scope of the present application. Therefore, the protection scope of the present application shall be subject to the protection scope of the claims.

## Claims

1. A capacitor, comprising:
a first electrode and a second electrode;
a laminated structure comprising a first conductive layer, at least one dielectric layer and at least one second conductive layer, wherein the first conductive layer comprises at least one groove-shaped support, the at least one dielectric layer and the at least one second conductive layer cover the at least one groove-shaped support, and the first conductive layer, the at least one dielectric layer and the at least one second conductive layer form a structure that a dielectric layer and a conductive layer are adjacent to each other; and
an interconnection structure configured to at least connect the first electrode and the second electrode to two adjacent conductive layers respectively.

2. The capacitor according to claim 1, wherein the at least one groove-shaped support is a plurality of groove-shaped supports, and the plurality of groove-shaped supports are electrically connected to each other.

3. The capacitor according to claim 2, wherein the plurality of groove-shaped supports form a grid structure in a cross section, or bottoms of the plurality of groove-shaped supports are electrically connected through a conductive layer.

4. The capacitor according to any one of claims 1 to 3, wherein the capacitor further comprises:
an insulating structure, wherein the insulating structure clads the laminated structure, and the interconnection structure is disposed in the insulating structure.

5. The capacitor according to claim 4, wherein the insulating structure comprises:
a first insulating layer, wherein an upper surface of the first insulating layer extends downward to form a first groove structure, the at least one groove-shaped support is disposed in the first groove structure, and the at least one second conductive layer is provided with at least one first step at an opening edge of the first groove structure; and
a second insulating layer, the second insulating layer covering the first insulating layer and the laminated structure.

6. The capacitor according to claim 5, wherein the interconnection structure comprises:
a first via, wherein the first via penetrates the first insulating layer and the second insulating layer, and is configured to electrically connect the first electrode to the first conductive layer; and
at least one second via disposed above the at least one first step and penetrating the second insulating layer, wherein the interconnection structure is electrically connected to the at least one second conductive layer through the at least one second via.

7. The capacitor according to claim 4, wherein the insulating structure comprises:
a third insulating layer, wherein the third insulating layer clads the laminated structure, and the at least one second conductive layer is provided with at least one second step in the third insulating layer.

8. The capacitor according to claim 7, wherein the at least one second conductive layer is provided with the at least one second step at a bottom of the third insulating layer close to the at least one groove-shaped support.

9. The capacitor according to claim 7, wherein the interconnection structure comprises:
a third via, wherein the first via penetrates the third insulating layer, and is configured to electrically connect the first electrode to the first conductive layer; and
at least one fourth via disposed above the at least one second step and penetrating the third insulating layer, wherein the interconnection structure is electrically connected to the at least one second conductive layer through the at least one fourth via.

10. The capacitor according to any one of claims 1 to 9, wherein the capacitor further comprises:
a substrate disposed under the laminated structure.

11. The capacitor according to claim 10, wherein the substrate is a wafer with a resistivity lower than a preset threshold value.

12. The capacitor according to claim 10, wherein the capacitor further comprises:
a third conductive layer disposed between the substrate and the laminated structure, the third conductive layer at least covering part of the substrate.

13. The capacitor according to claim 12, wherein the at least one groove-shaped support is electrically connected to the third conductive layer.

14. The capacitor according to claim 12, wherein the at least one groove-shaped support is electrically connected to the substrate through the third conductive layer.

15. The capacitor according to claim 14, wherein the third conductive layer is provided with at least one fifth via, and a bottom of the at least one groove-shaped support is disposed in the at least one fifth via.

16. The capacitor according to any one of claims 12 to 15, wherein an upper surface of the substrate extends downward to form a second groove structure, and the third conductive layer is disposed in the second groove structure.

17. The capacitor according to any one of claims 1 to 16, wherein the capacitor further comprises:
a fourth insulating layer, wherein the fourth insulating layer is provided with at least one sixth via, and a bottom of the at least one groove-shaped support is disposed in the at least one sixth via.

18. The capacitor according to any one of claims 1 to 17, wherein the interconnection structure is configured to electrically connect the first electrode to some or all odd-numbered conductive layer(s) in the laminated structure and electrically connect the second electrode to some or all even-numbered conductive layer(s) in the laminated structure.

19. A method for producing a capacitor, comprising:
producing at least one groove-shaped support on a substrate to obtain a first conductive layer;
producing at least one dielectric layer and at least one second conductive layer on the first conductive layer to obtain a laminated structure, wherein the at least one dielectric layer and the at least one second conductive layer cover the at least one groove-shaped support, and the first conductive layer, the at least one dielectric layer and the at least one second conductive layer form a structure that a dielectric layer and a conductive layer are adjacent to each other;
producing an insulating structure comprising an interconnection structure on the laminated structure; and
producing a first electrode and a second electrode on the insulating structure, wherein the first electrode and the second electrode are at least connected to two adjacent conductive layers respectively.

20. The method according to claim 19, wherein the producing the at least one groove-shaped support on the substrate to obtain the first conductive layer comprises:
forming a first insulating layer on the substrate;
forming a first groove penetrating the first insulating layer;
filling the first groove with a first material;
forming at least one second groove penetrating the first material;
producing a conductive layer conformal to an inner wall of the at least one second groove on an upper surface of the at least one second groove;
filling the at least one second groove with a second material;
removing a second material and a conductive layer that are above the first insulating layer; and
removing a second material in the at least one second groove to form the first conductive layer.

21. The method according to claim 20, wherein the producing the at least one dielectric layer and the at least one second conductive layer on the first conductive layer to obtain the laminated structure comprises:
producing the at least one dielectric layer and the at least one second conductive layer on the first conductive layer; and
forming at least one first step of the at least one second conductive layer at an opening edge of the first groove to obtain the laminated structure.

22. The method according to claim 21, wherein the producing the insulating structure comprising the interconnection structure on the laminated structure comprises:
producing a second insulating layer on the laminated structure and the first insulating layer;
forming a first via penetrating the first insulating layer and the second insulating layer;
forming at least one second via penetrating the second insulating layer above the at least one first step; and
filling the first via and the at least one second via with a conductive material.

23. The method according to claim 22, wherein the producing the first electrode and the second electrode on the insulating structure comprises:
forming the first electrode above the first via and/or above the second via corresponding to some or all odd-numbered conductive layer(s) in the laminated structure; and
forming the second electrode above the second via corresponding to some or all even-numbered conductive layer(s) in the laminated structure.

24. The method according to any one of claims 20 to 23, wherein the substrate is a wafer with a resistivity lower than a preset threshold value.

25. The method according to any one of claims 20 to 23, wherein the forming the first insulating layer on the substrate comprises:
forming a third conductive layer on the substrate; and
forming the first insulating layer on the third conductive layer.

26. The method according to claim 25, wherein the forming the first groove penetrating the first insulating layer comprises:
forming the first groove penetrating the first insulating layer and the third conductive layer.

27. The method according to claim 25, wherein the forming the first insulating layer on the third conductive layer comprises:
forming a fourth insulating layer on the third conductive layer; and
forming the first insulating layer on the fourth insulating layer;
wherein the forming the at least one second groove penetrating the first material comprises:
forming the at least one second groove penetrating the first material and the fourth insulating layer.

28. The method according to claim 19, wherein the producing the at least one groove-shaped support on the substrate to obtain the first conductive layer comprises:
forming a third material on the substrate;
forming at least one third groove penetrating the third material;
producing a conductive layer conformal to an inner wall of the at least one third groove on an upper surface of the at least one third groove;
filling the at least one third groove with a fourth material;
removing a fourth material and a conductive layer that are above the third material; and
removing a third material and a fourth material above the substrate to form the first conductive layer.

29. The method according to claim 28, wherein the producing the at least one dielectric layer and the at least one second conductive layer on the first conductive layer to obtain the laminated structure comprises:
producing the at least one dielectric layer and the at least one second conductive layer on the first conductive layer; and
forming at least one second step of the at least one second conductive layer on the substrate to obtain the laminated structure.

30. The method according to claim 29, wherein the producing the insulating structure comprising the interconnection structure on the laminated structure comprises:
producing a third insulating layer on the laminated structure;
forming a third via penetrating the third insulating layer;
forming at least one fourth via penetrating the third insulating layer above the at least one second step; and
filling the third via and the at least one fourth via with a conductive material.

31. The method according to claim 30, wherein the producing the first electrode and the second electrode on the insulating structure comprises:
forming the first electrode above the third via and/or above the fourth via corresponding to some or all odd-numbered conductive layer(s) in the laminated structure; and
forming the second electrode above the fourth via corresponding to some or all even-numbered conductive layer(s) in the laminated structure.

32. The method according to any one of claims 28 to 31, wherein the substrate is a wafer with a resistivity lower than a preset threshold value.

33. The method according to any one of claims 28 to 31, wherein the forming the third material on the substrate comprises:
forming a third conductive layer on the substrate; and
forming the third material on the third conductive layer.

34. The method according to claim 33, wherein the forming the at least one third groove penetrating the third material comprises:
forming the at least one third groove penetrating the third material and the third conductive layer.

35. The method according to claim 33, wherein the forming the third material on the third conductive layer comprises:
forming a fourth insulating layer on the third conductive layer; and
forming the third material on the fourth insulating layer;
wherein the forming the at least one third groove penetrating the third material comprises:
forming the at least one third groove penetrating the third material and the fourth insulating layer.

36. A capacitor, comprising:
the capacitor produced by the method according to any one of claims 19 to 35.
